# EUROPÄISCHE PATENTANMELDUNG

(11) **EP 1 251 627 A2**
(43) Veröffentlichungstag der Anmeldung: **23.10.2002**
(21) Anmeldenummer: 02007591.7
(22) Anmeldetag: 04.04.2002
(51) Int. Cl.: H02K 11/00, H05K 5/02

(54) **Elektromotorischer Antrieb**

(30) Priorität: 14.04.2001 DE 20106518 U
(71) Anmelder: Dewert Antriebs- und Systemtechnik GmbH & Co. KG, D-32278 Kirchlengern (DE)
(72) Erfinder: Roither, Andreas, 32130 Enger (DE); Bokämper, Ralf, 32312 Lübbecke (DE)
(74) Vertreter: Dantz, Jan Henning

(57) **Zusammenfassung**

Ein elektromotorischer Möbelantrieb mit wenigstens einem von einem Motor antreibbaren Antriebszug, der in einem Gehäuse angeordnet ist und der mit einer Steuereinheit ausgestattet ist, die in einem Steuergehäuse angeordnet ist und der eine Stromversorgungseinrichtung beinhaltet, der wenigstens einen Transformator enthält, soll so gestaltet werden, dass die Anzahl der benötigten Bauteile deutlich verringert wird. Darüber hinaus soll zumindest das Steuergehäuse so abgedichtet werden, dass auch die Anforderungen im Krankenhaus- und Nasszellenbereich erfüllt sind.

Erfindungsgemäß ist das Steuergehäuse 10 der Steuereinheit als Mehrkammergehäuse ausgebildet. Die elektrische Baugruppe ist in einer gemeinsamen Kammer angeordnet. Das Steuergehäuse 10 ist entweder außen am Gehäuse des Möbelantriebes angeordnet oder an geeigneter Stelle außerhalb des Möbelantriebes platziert. In allen Kammern oder auch nur in bestimmten Kammern sind federnde Rastzungen 20, 22 vorgesehen, um die elektrischen und/oder elektronischen Bauteile schraubenlos zu befestigen. In bevorzugter Ausführung besteht das Gehäuse aus einem einseitig offenen und einstükkigen Gehäuseteil 10 und einem flachen Deckel 18.

Der erfindungsgemäße Möbelantrieb ist besonders für Krankenhaus- und Pflegebetten geeignet.

## Beschreibung

Die Erfindung betrifft einen elektromotorischen Antrieb, insbesondere für Möbel, mit wenigstens einem von einem Motor antreibbaren Antriebszug, welcher in einem Gehäuse angeordnet ist, und mit einer in einem Steuergehäuse angeordneten Steuereinheit und mit einer wenigstens einen Transformator enthaltenden Stromversorgungseinrichtung.

Der in Rede stehende elektromotorische Antrieb ist in vielen Ausführungen bekannt. Er kann als Einzelantrieb mit einem Motor und einem Antriebszug oder auch als Antrieb mit mehreren Motoren und mehreren Antriebszügen ausgebildet sein. Die Antriebe sind mit Gleich- oder Wechselstrommotoren ausgerüstet, die über die Steuereinheit per Relais und/oder elektronische Schaltmittel über Bedienungsgeräte bzw. Handschalter betätigt werden können, wobei die Steuersignale drahtlos oder drahtgebunden übertragen werden können. Aus Sicherheitsgründen handelt es sich bei den Motoren um Niedervoltmotoren, deren Betriebsspannung durch einen an das Stromversorgungsnetz angeschlossenen Transformator bereitgestellt wird. Je nach Motorart wird der heruntertransformierte Wechselstrom direkt oder nach einer Gleichrichtung und Siebung als Gleichstrom für die Motorversorgung verwendet.

Es sind Antriebe bekannt, bei denen das Gehäuse der Steuereinheit außerhalb des Gehäuses des Antriebes liegt, oder an diesem außen angesetzt ist. Es sind jedoch auch Antriebe bekannt, bei denen das Gehäuse so ausgelegt ist, dass die Steuereinheit einschließlich des Transformators innerhalb des Gehäuses montiert ist. Ferner ist es auch bekannt, dass der Transformator extern als sogenannter Beistelltransformator ausgebildet ist, und/oder dass die gesamte Stuereinheit außerhalb des Antriebes getrennt aufgestellt werden kann. Es können auch zusätzlich weitere Antriebe für unterschiedliche Bewegungsfunktionen des Möbels angeschlossen werden.

Derartige Antriebe haben sich in der Praxis bewährt. Sie werden jedoch für unterschiedliche Bereiche angewendet, beispielsweise als Antriebe für Möbel in der Wohnung, als Antriebe für Möbel in einem Pflegeheim, als Antriebe für Nassräume oder auch als Antriebe im Krankenhausbereich. Für die verschiedenen Anwendungsbereiche werden auch unterschiedliche Anforderungen gestellt. Dies gilt besonders für die Dichtigkeit der Gehäuse und insbesondere des Steuergehäuses. So kann es erforderlich werden, bestehende Gehäuse bzw. Steuergehäuse aufwendig nachzurüsten, wobei es aufgrund der relativ geringen Einbauräume am Möbel häufig nicht möglich ist, so dass beispielsweise die Dichtigkeit erhöhende Abdeckhauben nicht verwendbar sind. Es ist außerdem bekannt, dass die Gehäuse durch spezielle Dichtungen in aufwendiger Weise abgedichtet werden, wodurch zusätzliche Teile notwendig werden, so dass die Teilevielfalt dadurch noch erhöht wird.

Der Erfindung liegt die Aufgabe zugrunde, einen elektromotorischen Antrieb der eingangs näher beschriebenen Art so zu gestalten, dass die Anzahl der insgesamt benötigten Bauteile deutlich verringert wird. Ferner soll erreicht werden, dass zumindest das Steuergehäuse eine solche Dichtigkeit aulweist, dass auch die Anforderungen im Krankenhaus- und Nasszellenbereich erfüllt sind.

Die gestellte Aufgabe wird gelöst, indem das Steuergehäuse der Steuereinheit als Mehrkammergehäuse ausgebildet ist, und dass vorzugsweise die eine elektrische oder elektronische Baugruppe bildenden Bauelemente in einer gemeinsamen Kammer angeordnet sind, und dass das Steuergehäuse außerhalb des Gehäuses des elektromotorischen Antriebes oder außen am Gehäuse des elektromotorischen antriebs plazierbar.

Das vollkommen vom elektromotorischen Antrieb getrennte Steuergehäuse nimmt nunmehr alle Steuerungsbauteile inklusive der Versorgungsspannungsquellen auf und ermöglicht alle Zusatzfunktionen, wie z.B. den Anschluß externer Sensoren, Akkumulatoren und dergleichen. Da die Baugruppe bildenden Bauelemente in einer Kammer angeordnet sind, ist die Abdichtung in einfachster Weise möglich. Damit zumindest teilweise mechanische Befestigungselemente entfallen, ist vorgesehen, dass in allen oder in bestimmten Kammern federnde Rastzungen zur schraubenlosen Befestigung von elektrischen und/oder elektronischen Bauteilen vorgesehen sind. So kann beispielsweise die in eine Kammer eingelegte Steuerplatine durch die federnden Rastzungen festgelegt werden. Ferner kann der Transformator ebenfalls über angepasste federnde Rastzungen festgesetzt werden. Durch die einzelnen Kammern wird auch ein hoher Sicherheitsstandard erreicht. Zweckmäßigerweise besteht das Gehäuse aus einem einseitig offenen und einstückigen Gehäuseteil und einem flachen Deckel, der mit dem Gehäuseteil beispielsweise durch Schrauben verbunden ist. Das Gehäuseteil ist so ausgelegt, dass die Bauteile von unten her in das Gehäuse vorzugsweise durch Montageautomaten eingesetzt werden können. Eine sichere und kostengünstige Abdeckung wird erreicht, indem der äußere Randbereich des flachen Deckels eine vorzugsweise umlaufende und einstückig mit dem Deckel ausgebildete Dichtlippe oder einen Dichtsteg aufweist, die bzw. der vorzugsweise im Zweikomponenten- Spritzgußverfahren hergestellt ist. Die Dichtlippe oder der Dichtsteg greifen zweckmäßigerweise in das Gehäuseteil ein, indem dort eine Aussparung oder eine Nut vorgesehen ist. Zweckmäßigenveise ist eine Kammer so ausgelegt, dass der Anschluß für das Netzkabel in einem separaten Fach angeordnet ist. Es kann auch möglich sein, dass dieser Anschluß zwei Durchführungen aufweist, die beispielsweise um 90 Grad versetzt zueinander stehen. Dadurch kann das Netzkabel geradlinig in das Gehäuseteil geführt werden, so dass ein Umlenken vermieden wird. Das Netzkabel wird mittels einer Halteplatte, die bevorzugt im Inneren des Gehäuseteils angeordnet ist festgesetzt. Diese Halteplatte sollte auch eine Durchführung haben, um das Netzkabel an die Platine anzuschließen. Diese Netzanschlußplatine hat wenigstens eine Durchführung und kann auch Sicherungen aufnehmen, die dadurch leicht auszuwechseln sind. Eine der Kammern sollte so ausgelegt sein, dass ein oder mehrere Transformatoren aufgenommen werden können. Die Transformatoren können unterschiedlicher Bauart sein, beispielsweise ein EI-Kern oder ein Ringkerntransformator sein. Außerdem könnte ein Transformator von größerer Leistung eingelegt werden, ohne dass die Sicherheit herabgesetzt wird. Die Haltestege sollten so ausgelegt sein, dass sowohl ein rechteckiger EI-Kerntrafo als auch ein runder Ringkerntrafo festgesetzt werden kann. Darüber hinaus kann auch jeder Transformator durch eine aufgeschraubte Halteplatte in der Lage gesichert werden. Dadurch entfällt das selbstständige Lösen aufgrund von unterschiedlichen Einwirkungen. Ferner ist noch vorgesehen, dass als Spannungsversorgungsmöglichkeit ein an sich bekanntes Akkupaket außen am Gehäuseteil durch Rastung festgelegt werden kann. Dadurch wird eine netzunabhängige Versorgung sichergestellt. Damit das Gehäuse in vielfältigster Weise am Möbel montiert werden kann, und auch ein Aufstellen auf dem Fußboden möglich ist, ist noch vorgesehen, dass am Gehäuseteil mindestens zwei Haltelaschen angeformt sind. Diese Haltelaschen sollten in bevorzugter Ausführung rechtwinklig zur Wand des Gehäuses stehen, weiterhin sind für Führungslaschen, Haltestege oder ähnliche Bauteile von vorhandenen Motoren korrespondierende Führungs- und / oder Rastmittel vorgesehen

Durch die Positionierung des Steuergehäuses außerhalb des Gehäuses des elektromotorischen Antriebes ist in einfachster Weise der Zugriff auf die Steuereinheit möglich, beispielsweise für Installations- oder Wartungsarbeiten.

Das erfindungsgemäße Steuergehäuse ist universell für alle Antriebe einsetzbar, da vielfältigste Funktionen möglich sind, für die bislang unterschiedliche und vielfältige zusätzliche Ausrüstungen mit einer entsprechenden Teilevielfalt notwendig waren. Gleichzeitig ist durch die besondere konstruktive Gestaltung die Wirtschaftlichkeit insbesondere durch die Verkürzung der Montagezeiten und auch der Materialien gestiegen. Es ist möglich, Funktionsbaugruppen von bereits bestehenden aber unterschiedlichen Antriebskonzeptionen aufgrund des hohen Integrationsgrades mitzuverwenden, wobei eine übliche Neukonstruktion nicht notwendig ist.

Anhand der beiliegenden Zeichnungen wird die Erfindung noch näher erläutert. Es zeigen:
- Figur 1: das offene Gehäuseteil in einer perspektivischen Darstellung, mit Blick auf die offene Seite,
- Figur 2: das Gehäuseteil in einer Draufsicht,
- Figur 3: das Gehäuseteil nach den Figuren 1 und 2 in Schnittdarstellung,
- Figur 3a: eine Einzelheit 3a nach der Figur 3
- Figur 4: den Deckel mit Blick auf die Innenfläche
- Figur 5: einen Schnitt längs der Linie V-V in der Figur 4,
- Figur 6: einen Schnitt längs der Linie VI-VI in der Figur 4
- Figur 7: eine Einzelheit VII in der Figur 5 und
- Figur 8: eine Einzelheit VIII in der Figur 6.

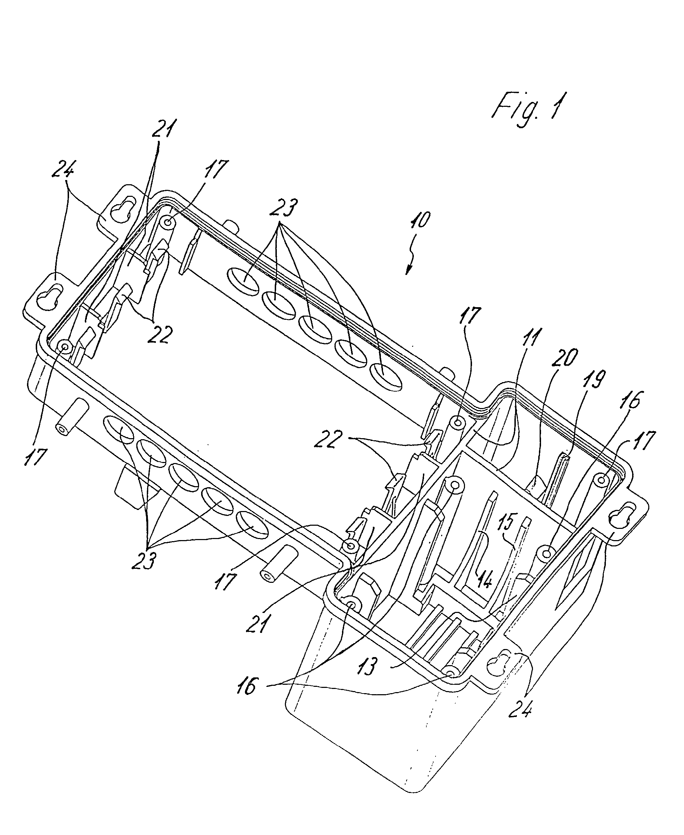

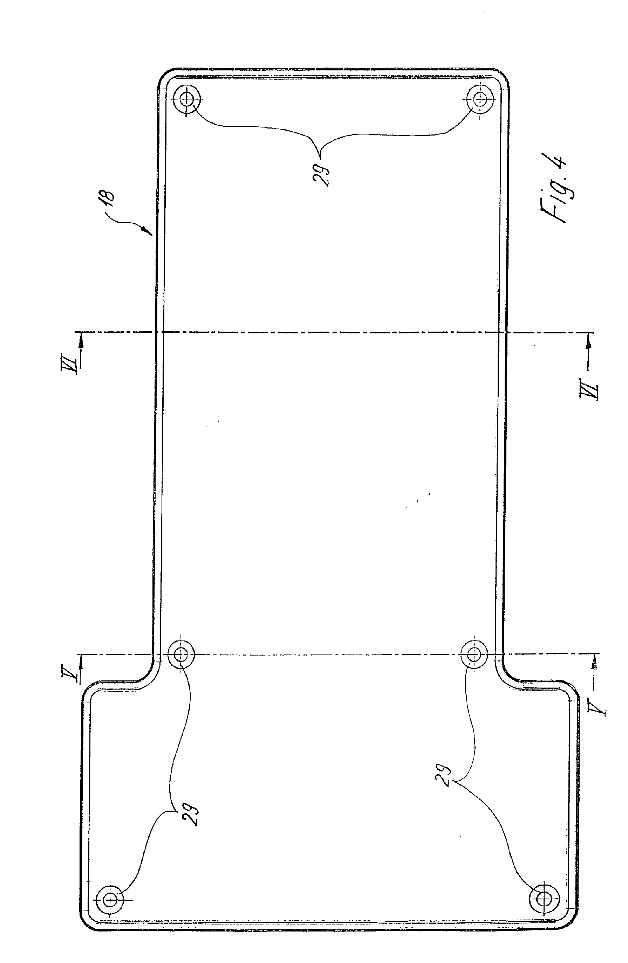

In der Figur 1 ist das Gehäuseteil 10 des elektromotorischen Antriebes im unbestückten Zustand dargestellt. Es ist aus Kunststoff gefertigt und beinhaltet mehrere Kammern, die durch Trennwände 11 voneinander räumlich getrennt sind. Die in der Darstellung nach der Figur 1 rechte Kammer hat eine wesentlich größere Tiefe als die linke Kammer. In dieser Kammer sind Führungs- und Haltestege 12, 13 für einen EI-Kerntransformator vorgesehen. Es ist jedoch nicht notwendig, dass der elektromotorische Antrieb mit einem solchen Transformator ausgerüstet wird. Es sind deshalb zwei weitere Führungs- und Haltestege 14, 15 vorgesehen, um beispielsweise einen Ringkerntransformator festzulegen. Der eingesetzte Transformator wird durch eine nicht dargestellte Halteplatte zusätzlich gesichert. Dazu sind in der rechten Kammer vier Verschraubungsdome 16 vorgesehen, um diese Halteplatte festzulegen. Das Gehäuseteil 10 ist außerdem mit weiteren Verschraubungsdomen 17 ausgestattet, um einen in der Figur 4 als Einzelteil dargestellten Deckel 18 mit dem Gehäuseteil 10 zu verbinden. In einer weiteren Kammer des Gehäuseteiles 10 ist ein Halteprofil 19 für eine Netzkabelplatine vorgesehen, die durch eine federnde Rastzunge 20 in ihrer Lage gesichert ist. Die nicht dargestellte Steuerplatine wird in der linken Kammer des Gehäuseteiles 10 festgelegt. Dazu sind in dieser Kammer vier Auflagestege 21 vorgesehen. Die Sicherung erfolgt ebenfalls durch federnde Rastzungen 22. Die die linke Kammer begrenzenden Wandungen sind mit mehreren Öffnungen 23 versehen, um Motoren, Bedienungselemente, Sensoren, Akkuanschlüsse und dergleichen mit der nicht dargestellten Steuerplatine zu verbinden. Die Figur 1 zeigt, dass die den Transformator und die Netzkabelplatine aufnehmenden Kammern in der Tiefe bzw. Höhe deutlich größer sind als die die Steuerplatine aufnehmende Kammer. Durch die räumliche Trennung dieser Bauteile ist eine größtmögliche Sicherheit gegeben. Aus Darstellungsgründen liegt die offene Seite des Gehäuseteils 10 in der Figur 1 oben. Für die Bestückung mit den elektronischen Bauteilen, liegt das Gehäuseteil jedoch mit der offenen Seite nach oben, da die Bestückung durch Montageautomaten erfolgt. Zur Festlegung an einem Möbel oder sonstigen Bauteilen sind an das Gehäuseteil an der Außenseite noch vier Befestigungslaschen 24 angeformt, die senkrecht zu den Wandungen stehen und mit schlüssellochartigen Ausnehmungen versehen sind. Weitere Führungs- und Rastmittel zur Anbringung an bestehenden Bauteilen sind vorgesehen aber nicht dargestellt

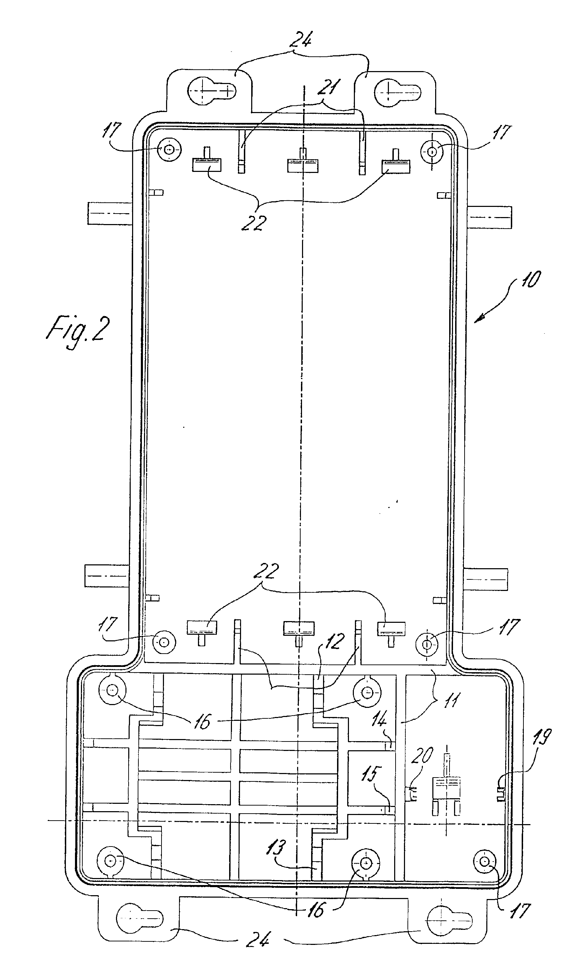

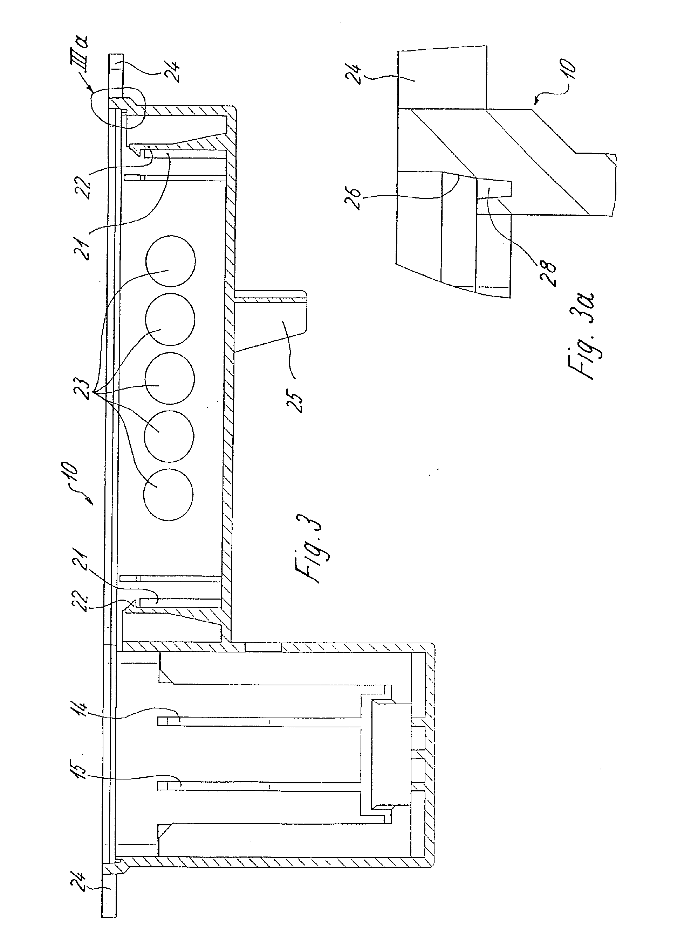

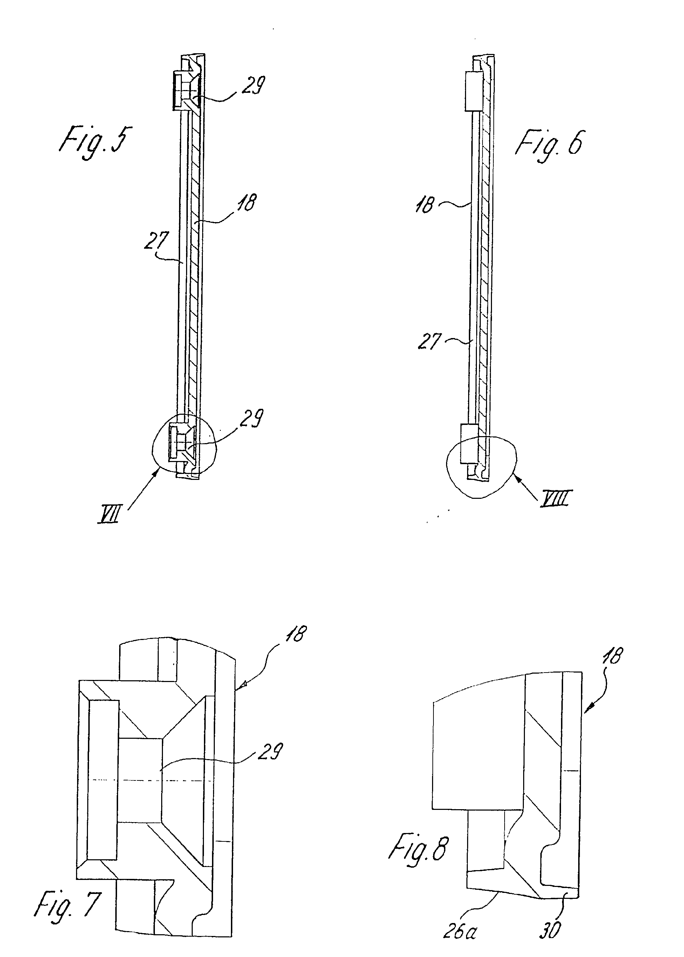

Die Figur 2 zeigt das Gehäuseteil 10 in einer Draufsicht. Die einzelnen Bauelemente sind mit den gleichen Bezugszeichen wie in der Figur 1 bezeichnet. Die Figur 3 zeigt das Gehäuseteil 10 im Vertikalschnitt. Die Figur 3 zeigt außerdem, dass die Kammer des Gehäuseteils 10 mit der geringeren Tiefe an der der offenen Seite gegenüberliegenden Seite mit einer Halterung 25 für Akkumulatoren versehen ist. Dadurch kann der elektromotorische Antrieb auch unabhängig vom Netz betrieben werden. Die Figur 3a zeigt, dass der die Öffnung begrenzende Rand zunächst gradlinig verläuft, und anschließend eine Schrägfläche aufweist, wodurch der in der Figur 4 dargestellte Deckel 18 fest gegen die Schrägfläche 26 gezogen wird. Dadurch wird bereits eine Dichtigkeit erzielt. Diese wird noch erhöht, da an dem Deckel in noch näher beschriebener Weise eine Dichtlippe 27 angeformt ist, die in einen nutartigen Kanal 28 eingreift, wie die Figur 5 zeigt.

Die Figur 4 zeigt den flachen Deckel 18 für den elektromotorischen Antrieb. Daraus ergibt sich nochmals, dass nicht nur die Tiefe bzw. Höhe der die Transformatoren und die Netzkabelplatine aufnehmenden Kammer größer ist als die die Steuerplatine aufnehmende Kammer, sondern dass diese Kammern auch in der Breite größer sind. Der Deckel ist mit mehreren ausgesenkten Bohrungen 29 versehen, um die Befestigungsschrauben hindurchzuführen. Diese werden in die Verschraubungsdome 17 eingedreht. Die Figur 5 zeigt, dass vorzugsweise Senkkopfschrauben zur Festlegung des Deckels 18 verwendet werden. Außerdem zeigt die Figur 5 und auch die Figur 6, dass innenseitig an den Deckel eine umlaufende Dichtlippe 27 einstückig angeformt ist. Außerdem zeigt die Figur 5 in Verbindung mit der Figur 7, dass die Bohrungen durch die konische Aussenkung selbdichtend sind. Die Figur 6 zeigt in der Verbindung mit der Figur 8, dass der Deckel 18 an der dem Gehäuseteil 10 abgewandten äußeren Seite mit einem erhöhten Randsteg 30 ausgestattet ist. Außerdem zeigt die Figur 8, dass der Deckel 18 auch mit einer Schrägfläche 26a ausgestattet ist, die im verschraubten Zustand die Schrägfläche 26 des Gehäuseteils 10 kontaktiert.

Die Erfindung ist nicht auf das dargestellte Ausführungsbeispiel beschränkt. Wesentlich ist, dass die einzelnen Funktionsgruppen innerhalb des Steuergehäuses 10 durch Trennwände 11 voneinander getrennt sind, und dass ohne besondere Vorkehrungen das Steuergehäuse 10 eine Dichtigkeit aufweist, die auch einen Einsatz in in Feucht- und Naßräumen ermöglicht.

## Patentansprüche

1. Elektromotorischer Antrieb insbesondere für Möbel mit wenigstens einem von einem Motor antreibbaren Antriebszug, welche in einem Gehäuse angeordnet sind und mit einer in einem Steuergehäuse angeordneten Steuereinheit und mit einer wenigstens einen Transformator enthaltenden Stromversorgungseinrichtung, **dadurch gekennzeichnet, dass** das Steuergehäuse (10) der Steuereinheit als Mehrkammergehäuse ausgebildet ist und dass vorzugsweise die eine elektrische Baugruppe bildenden Bauelemente in einer gemeinsamen Kammer angeordnet sind, und dass das Steuergehäuse (10) außerhalb des Gehäuses des elektromotorischen Antriebes oder außen am Gehäuse des elektromotorischen Antriebs platzierbar ist..

2. Elektromotorischer Antrieb nach Anspruch 1, **dadurch gekennzeichnet, dass** in allen oder in bestimmten Kammern federnde Rastzungen (20, 22) zur schraubenlosen Befestigung von elektrischen und/oder elektronischen Bauteilen vorgesehen sind.

3. Elektromotorischer Antrieb nach Anspruch 1 oder 2, **dadurch gekennzeichnet, dass** das Gehäuse aus einem einseitig offenen und einstückigen Gehäuseteil (10) und einem flachen Deckel (18) besteht.

4. Elektromotorischer Antrieb nach einem oder mehreren der vorhergehenden Ansprüche 1 bis 3, **dadurch gekennzeichnet, dass** in dem äußeren Randbereich des flachen Deckels (18) eine vorzugsweise umlaufende und einstückig mit dem Deckel (18) ausgebildete Dichtlippe (27) oder ein Dichtsteg angeformt ist, und daß die Dichtlippe oder der Dichtsteg vorzugsweise im Zweikomponenten-Spritzgußverfahren gefertigt ist.

5. Elektromotorischer Antrieb nach einem oder mehreren der vorhergehenden Ansprüche 1 bis 4, **dadurch gekennzeichnet, dass** das Gehäuseteil (10) mit mehreren Anschlüssen für elektrische Kabel ausgestattet ist.

6. Elektromotorischer Antrieb nach einem oder mehreren der vorhergehenden Ansprüche 1 bis 5, **dadurch gekennzeichnet, dass** in einer Kammer eine Netzanschlußplatine durch Rastung festlegbar ist.

7. Elektromotorischer Antrieb nach einem oder mehreren der vorhergehenden Ansprüche 1 bis 6, **dadurch gekennzeichnet, dass** außenseitig am Gehäuseteil (10) mehrere Haltelaschen (24) angeformt sind.

8. Elektromotorischer Antrieb nach einem oder mehreren der vorhergehenden Ansprüche 1 bis 7, **dadurch gekennzeichnet, dass** in einer Kammer derartige Stege vorgesehen sind, dass wahlweise Transformatoren unterschiedlicher Bauarten festlegbar sind.

9. Elektromotorischer Antrieb nach einem oder mehreren der vorhergehenden Ansprüche 1 bis 8, **dadurch gekennzeichnet, dass** außenseitig am Gehäuseteil (10) ein Halteprofil (19) zur Festlegung einer Hilfsspannungsquelle vorgesehen sind.

10. Elektromotorischer Antrieb nach einem oder mehereren der vorhergehenden Ansprüche 1 bis 9, **dadurch gekennzeichnet, dass** der in dem Gehäuseteil (10) festgelegte Transformator mittels einer Halteplatte gesichert ist.

11. Elektromotorischer Antrieb nach einem oder mehreren der vorhergehenden Ansprüche 1 bis 10, **dadurch gekennzeichnet, dass** an einer eine Öffnung dr Gehäusekammer verschließenden Platte aus einer Zugentlastung für ein Netzkabel angeordnet ist oder die Platte als Zugentlastung ausgebildet ist.

12. Elektromotorischer Antrieb nach einem oder mehreren der vorhergehenden Ansprüche 1 bis 11, **dadurch gekennzeichnet, dass** in einer Kammer des Gehäuseteils (10) eine Netzanschlußplatine festlegbar ist, und dass die Netzanschlußplatine mit einer Sicherung oder mit mehreren Sicherungen bestückt ist.

13. Elektromotorischer Antrieb nach einem oder mehreren der vorhergehenden Ansprüche 1 bis 12, **dadurch gekennzeichnet, dass** der Deckel (18) an der dem Gehäuseteil (10) zugewandten Seite eine Schrägfläche (26) aufweist, die eine entsprechend geneigte Schrägfläche (26a) des Gehäuseteils (10) dichtend kontaktiert.
